# EUROPEAN PATENT APPLICATION

(11) **EP 4 723 844 A2**
(43) Date of publication of application: **08.04.2026**
(21) Application number: 25199211.1
(22) Date of filing: 29.08.2025
(51) Int. Cl.: H10H 20/01, H10P 72/00, H10H 29/02, H10P 72/30, B25J 15/06

(54) **TRANSFER DEVICE FOR LIGHT-EMITTING ELEMENT, DISPLAY DEVICE INCLUDING LIGHT-EMITTING ELEMENT, ELECTRONIC DEVICE INCLUDING DISPLAY DEVICE AND METHOD USING TRANSFER DEVICE**

(30) Priority: 12.09.2024 KR 20240124523
(71) Applicant: Samsung Display Co., Ltd., Yongin-si, Gyeonggi-do 17113 (KR)
(72) Inventor: HAN, Jeong Won, 17113 Yongin-si (KR)
(74) Representative: Taor, Simon Edward William

(57) **Abstract**

A transfer device for light-emitting element includes a first transfer head, a second transfer head disposed below the first transfer head, a stamp disposed below the second transfer head, a tilting adjustment member for adjusting a tilting of the second transfer head and an air supply member for forming an air layer by spraying air downward from one surface of the second transfer head.

## Description

The application claims priority to Korean Patent Application No. 10-2024-0124523, filed on September 12, 2024.

### BACKGROUND

### 1. Field

The disclosure relates to a transfer device for light-emitting element and a method for transferring the light-emitting elements using the device.

### 2. Description of the Related Art

The importance of display devices is increasing along with the development of multimedia. In response to this, various types of display devices such as organic light-emitting display devices ("OLED") and liquid crystal display devices ("LCD"), etc., are being used.

A display panel such as a light-emitting display panel or a liquid crystal display panel is included as a device that displays an image of a display device. Among them, the light-emitting display panel may include a light-emitting diode ("LED"), and as a light-emitting diode, an organic light-emitting diode that uses an organic substance as a fluorescent material or an inorganic light-emitting diode that uses an inorganic substance as a fluorescent material is included.

### Summary

When manufacturing a display panel that uses an inorganic light-emitting diode as a light-emitting diode, manufacturing devices for arranging micro LED on a substrate of the display panel is desired be developed.

However, features of the disclosure are not restricted to the one set forth herein. The above and other features of the disclosure will become more apparent to one of ordinary skill in the art to which the disclosure pertains by referencing the detailed description of the disclosure given below.

In an embodiment of the disclosure, a light-emitting element transfer device includes a first transfer head, a second transfer head disposed below the first transfer head, a stamp disposed below the second transfer head, a tilting adjustment member for adjusting a tilting of the second transfer head and an air supply member for forming an air layer by spraying air downward from one surface of the second transfer head.

In an embodiment, the air supply member includes an air supply portion that supplies air, a spray head that is disposed on the surface of the second transfer head and has a hole through which air is sprayed and a spray line that penetrates the second transfer head and connects the air supply portion and the spray head.

In an embodiment, the hole is one of a single hole type or a porous type.

In an embodiment, the air supply portion is an air pump.

In an embodiment, the first transfer head has a cavity defining an opening facing downward, and a width of the opening is smaller than a width of the cavity.

In an embodiment, the second transfer head is divided into a first portion disposed inside the cavity, a third portion disposed outside the first transfer head, and a second portion disposed between the first portion and the third portion, and a width of the second portion is narrower than widths of the first portion and the third portion.

In an embodiment, the tilting adjustment member includes a first permanent magnet disposed on the first transfer head, and a second permanent magnet disposed on the first portion of the second transfer head and facing the first permanent magnet and having a repulsive force with the first permanent magnet.

In an embodiment, the second transfer head has a chuck on one side and absorbs the stamp by the chuck.

In an embodiment, the second transfer head is divided into a first portion disposed inside the cavity, a third portion disposed outside the first transfer head, a second portion disposed between the first portion and the third portion, and an inclined portion disposed between the first portion and the second portion, where a width of the second portion is narrower than a width of the first portion and a width of the third portion.

In an embodiment, the tilting adjustment member includes a plurality of second permanent magnets disposed in the first portion and the inclined portion, and a plurality of first permanent magnets disposed on the first transfer member corresponding to the plurality of second permanent magnets.

In an embodiment, the device further includes a pressure member disposed between the first transfer head and the second transfer head within a cavity of the first transfer head and pressing the second transfer head downward.

In an embodiment, the pressure member is a spring.

In an embodiment, the pressure member includes an elastic film disposed on the second transfer head within the cavity of the first transfer head, a gas pipe connected between the elastic film and the cavity, and a gas supply member supplying gas to the gas pipe.

In an embodiment, the first transfer head, the second transfer head, and the tilting adjustment member are air gyros.

In an embodiment, the spray head is provided in plural, and the spray heads are discontinuously disposed in a plurality around the stamp.

In an embodiment, the spray head is provided in plural, and the heads are continuously disposed to surround the stamp.

In an embodiment of the disclosure, a method for transferring a light-emitting element includes disposing an aforementioned transfer device on a substrate, the lowering the transfer device by forming an air layer between the second transfer head and the substrate by the air supply member, where a thickness of the air layer is thicker than a sum of a height of the stamp and a height of the light-emitting element, the adjusting a flatness of the transfer device to a flatness of the substrate and the lowering the second transfer head downward to pressurize the air layer to contact and transfer the light-emitting element to the substrate, where the thickness of the air layer is equal to the sum of the height of the stamp and the height of the light-emitting element.

In an embodiment, in the disposing the transfer mechanism on the substrate, where the light-emitting element disposed on the stamp is aligned on the substrate based on a first alignment key disposed on one side of the stamp and a second alignment key disposed on the substrate.

In an embodiment, in the adjusting to the flatness of the substrate, where the tilting adjustment member adjusts the second transfer head to adjust to the flatness of the substrate while the second transfer head is not in contact with the first transfer head.

In an embodiment, in the forming the air supply member forms an air layer between the second transfer head and the substrate and the lowering the transfer device by the air supply member, an air supply unit supplies air to a spray head along a spray line, so that the spray head sprays air in a downward direction to form the air layer.

According to an aspect, there is provided a light-emitting element transfer device as set out in claim 1. Additional features are set out in claims 2 to 12. According to an aspect, there is provided a method as set out in claim 13. Additional features are set out in claims 14 and 15.

Advantages and features of embodiments of the disclosure are to provide a light-emitting element transfer device capable of effectively transferring a light-emitting element and a transfer method using the device.

By an embodiment of the method for manufacturing a display panel, a high-precision alignment may be performed by securing the relative flatness of the substrate while the light-emitting element is not in contact with the substrate. Accordingly, the product quality of the display panel may be improved and the yield may be increased by reducing defects in the light-emitting element. In particular, the effect may be excellent on a large-area substrate.

However, the effects of the disclosure are not limited to the aforementioned effects, and various other effects are included in the specification.

### BRIEF DESCRIPTION OF THE DRAWINGS

The above and other embodiments, advantages and features of this disclosure will become more apparent by describing in further detail embodiments thereof with reference to the accompanying drawings.
FIG. 1 is a layout diagram illustrating an embodiment of a display device.
FIG. 2 is a diagram illustrating an embodiment of a pixel of FIG. 1.
FIG. 3 is a diagram illustrating another embodiment of a pixel of FIG. 1.
FIG. 4 is a cross-sectional view illustrating an embodiment of a display panel cut along line A-A' of FIG. 2.
FIG. 5 is a schematic diagram schematically illustrating an embodiment of a light-emitting element transfer device.
FIG. 6 is a schematic diagram schematically illustrating an embodiment of a transfer device.
FIG. 7 is a plan view of an embodiment of a spray head.
FIG. 8 a drawing to illustrate an embodiment of an operation of the air spray member in FIG. 7.
FIGS. 9 to 12 are plan views to illustrate the number and shape of a buffer member.
FIG. 13A is a drawing to illustrate the operation of a light-emitting element transfer device without a tilting adjustment member and a buffer member, and FIG. 13B is an enlarged view of a dot-dashed portion of FIG. 13A.
FIG. 14 is a schematic diagram schematically illustrating another embodiment of a transfer mechanism of a light-emitting element.
FIG. 15 a schematic diagram schematically illustrating another embodiment of a transfer mechanism of a light-emitting element.
FIG. 16 a schematic diagram schematically illustrating another embodiment of a transfer mechanism of a light-emitting element.
FIG. 17 a schematic diagram schematically illustrating another embodiment of a transfer mechanism of a light-emitting element.
FIG. 18 a schematic diagram schematically illustrating another embodiment of a transfer mechanism of a light-emitting element.
FIG. 19 a schematic diagram schematically illustrating another embodiment of a transfer mechanism of a light-emitting element.
FIG. 20 is a flow chart illustrating a light-emitting element transfer method.
FIGS. 21 to 25 are cross-sectional views to illustrate a light-emitting element transfer method.
FIG. 26 is a perspective view of a smart watch including a display device.
FIGS. 27 and 28 are perspective views of a virtual reality ("VR") device including a display device.
FIG. 29 is a perspective view of a VR device including a display device.
FIG. 30 is a perspective view illustrating a vehicle instrument cluster and center fascia including display devices.
FIG. 31 is a perspective view of a transparent display device including a display device.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying drawing figures, the thickness of layers and regions may be exaggerated for clarity.

Some of the parts which are not associated with the description may not be provided in order to describe embodiments of the disclosure.

It will also be understood that when a layer is referred to as being "on" another layer or substrate, it may be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, illustrative embodiments will be described with reference to the accompanying drawings.

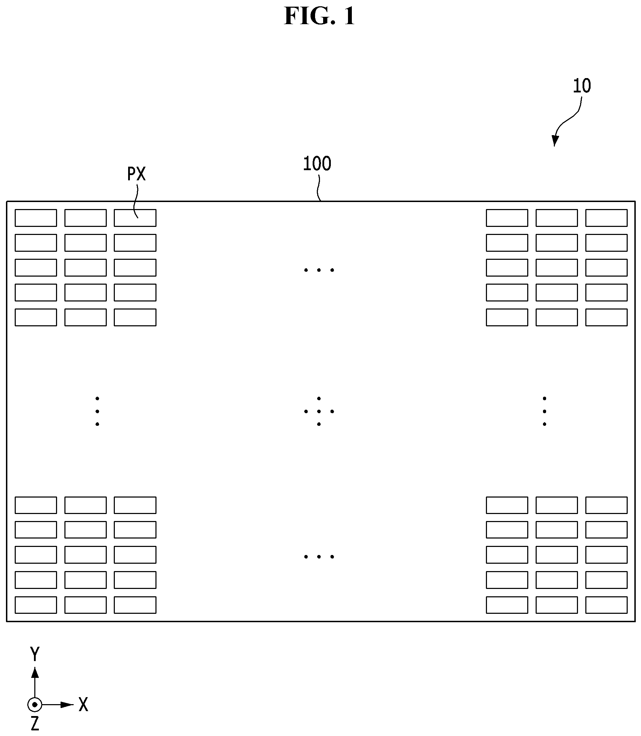

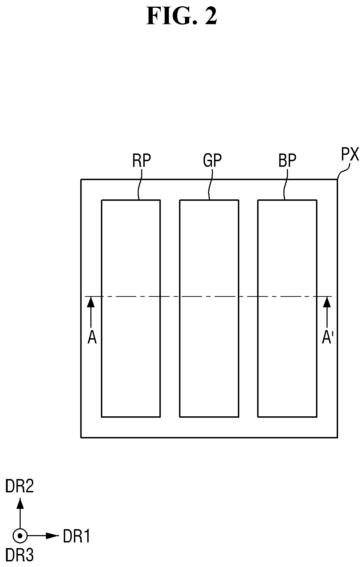

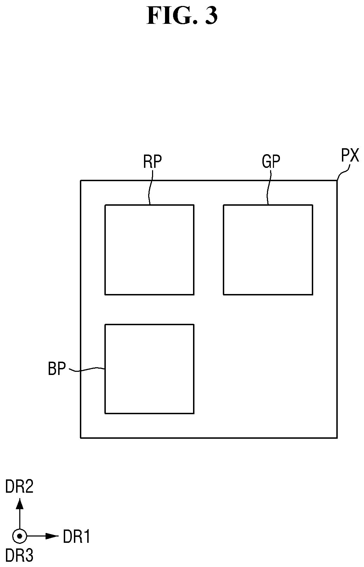

FIG. 1 is a layout diagram illustrating an embodiment of a display device. FIG. 2 is a diagram illustrating an embodiment of a pixel of FIG. 1. FIG. 3 is a diagram illustrating another embodiment of a pixel of FIG. 1.

Referring to FIGS. 1 to 3, a display device 10 is a device for displaying video or still images, such as mobile phones, smart phones, tablet personal computers ("PCs"), and portable electronic devices such as smart watches, watch phones, mobile communication terminals, electronic notebooks, e-books, portable electronic devices such as portable multimedia players ("PMP"), navigation, and ultra mobile PCs ("UMPC"), as well as display screens for a variety of products such as televisions, laptops, monitors, billboards, and the internet of things ("IoT").

The display panel 100 may be formed as a quadrangular plane, e.g., rectangular plane having a long side in a first direction DR1 and a short side in a second direction DR2 intersecting the first direction DR1. A corner where the long side in the first direction DR1 and the short side in the second direction DR2 meet may be formed rounded to have a predetermined curvature or formed at a right angle. The planar shape of the display panel 100 is not limited to a rectangle, and may be formed in other polygonal, circular, or oval shapes. The display panel 100 may be formed flat but is not limited thereto. In an embodiment, the display panel 100 is formed at left and right ends and may include curved portions with a constant curvature or a changing curvature. Additionally, the display panel 100 may be flexible, such as to be able to be bent, curved, bent, folded, or rolled, for example.

The display panel 100 may further include pixels PX for displaying an image, scan lines extending in the first direction DR1, and data lines extending in the second direction DR2. The pixels PX may be disposed in a matrix form in the first direction DR1 and the second direction DR2.

Each of the pixels PX may include a plurality of sub-pixels RP, GP, and BP as shown in FIGS. 2 and 3. In FIGS. 2 and 3, each of the pixels PX includes three sub-pixels RP, GP, and BP, that is, a first sub-pixel RP, a second sub-pixel GP, and a third sub-pixel BP, but embodiments of the disclosure are not limited thereto.

The first sub-pixel RP, the second sub-pixel GP, and the third sub-pixel BP may be connected to one of the data lines and at least one scan line among the scan lines.

Each of the first sub-pixel RP, the second sub-pixel GP, and the third sub-pixel BP may have a planar shape of a rectangle, a square, or a rhombus. In an embodiment, each of the first sub-pixel RP, the second sub-pixel GP, and the third sub-pixel BP may have a planar shape of a rectangle having a short side in the first direction DR1 and a long side in the second direction DR2, as shown in FIG. 2, for example. In an alternative embodiment, each of first sub-pixel RP, the second sub-pixel GP, and the third sub-pixel BP may have a planar shape of a square or a rhombus including sides having the same length in the first direction DR1 and the second direction DR2, as shown in FIG. 3.

As shown in FIG. 2, the first sub-pixel RP, the second sub-pixel GP, and the third sub-pixel BP may be disposed in the first direction DR1. In an alternative embodiment, one of the second sub-pixel GP and the third sub-pixel BP and the first sub-pixel RP may be disposed in the first direction DR1, and a remaining (the other) one and the first sub-pixel RP may be disposed in the second direction DR2. In an embodiment, as shown in FIG. 3, the first sub-pixel RP and the second sub-pixel GP may be disposed in the first direction DR1, and the first sub-pixel RP and the third sub-pixel BP may be disposed in the second direction DR2, for example.

In an alternative embodiment, one of the first sub-pixel RP and the third sub-pixel BP and the second sub-pixel GP may be disposed in the first direction DR1, and a remaining (the other) one and the second sub-pixel GP may be disposed in the second direction DR2. In an alternative embodiment, one of the first sub-pixel RP and the second sub-pixel GP and the third sub-pixel BP may be disposed in the first direction DR1, and the remaining one and the third sub-pixel BP may be disposed in the second direction DR2.

The first sub-pixel RP may include a first light-emitting element that emits first light, the second sub-pixel GP may include a second light-emitting element that emits second light, and the third sub-pixel BP may include a third light-emitting element that emits third light. Here, the first light may be light in a red wavelength band, the second light may be light in a green wavelength band, and the third light may be light in a blue wavelength band. The red wavelength band may be a wavelength band of about 600 nm to 750 nm, the green wavelength band may be a wavelength band of about 480 nm to 560 nm, and the blue wavelength band may be a wavelength band of about 370 nm to 460 nm, but the embodiments of the disclosure are not limited thereto.

Each of the first sub-pixel RP, the second sub-pixel GP, and the third sub-pixel BP may include an inorganic light-emitting element having an inorganic semiconductor as a light-emitting element that emits light. In an embodiment, the inorganic light-emitting element may be a micro light-emitting diode ("LED") of a flip-chip type, for example, but embodiments of the disclosure are not limited thereto.

As shown in FIGS. 2 and 3, the area of the first sub-pixel RP, the area of the second sub-pixel GP, and the area of the third sub-pixel BP may be substantially the same, but embodiments of the disclosure are not limited thereto. At least one of area of the first sub-pixel RP, the area of the second sub-pixel GP, and the area of the third sub-pixel BP may be different from another one. In an alternative embodiment, any two of the area of area of the first sub-pixel RP, the area of the second sub-pixel GP, and the area of the third sub-pixel BP may be substantially the same, and the remaining one may be different from the two. In an alternative embodiment, the area of the first sub-pixel RP, the area of the second sub-pixel GP, and the area of the third sub-pixel BP may be different from each other.

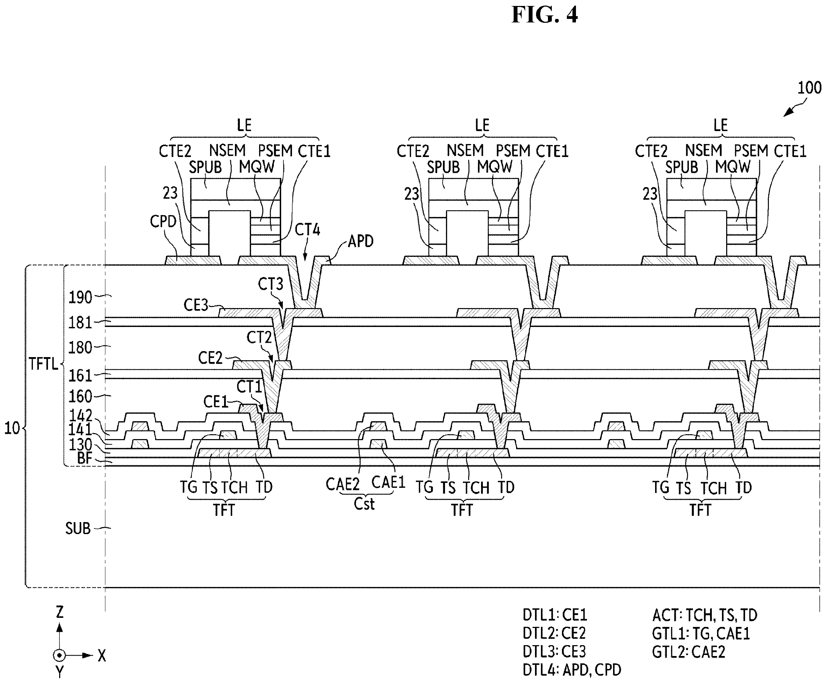

FIG. 4 is a cross-sectional view illustrating an embodiment of a display panel cut along line A-A' of FIG. 2.

Referring to FIG. 4, the display panel 100 may include a thin film transistor layer TFTL and light-emitting elements LE disposed on a substrate SUB. The thin film transistor layer TFTL may be a layer on which thin film transistors TFT are formed.

The thin film transistor layer TFTL may include an active layer ACT, a first gate layer GTL1, a second gate layer GTL2, a first data metal layer DTL1, a second data metal layer DTL2, a third data metal layer DTL3, and a fourth data metal layer DTL4. Further, the thin film transistor layer TFTL includes a buffer film BF, a gate insulating film 130, a first inter-insulating film 141, a second inter-insulating film 142, a first planarization film 160, a first insulating film 161, a second planarization film 180, and a second insulating film 181.

The substrate SUB may be a base substrate or a base member for supporting a display device. The substrate SUB may be a rigid substrate including or consisting of glass, but the embodiments of the disclosure are not limited thereto. The substrate SUB may be a flexible substrate capable of bending, folding, rolling, etc. In this case, the substrate SUB may include an insulating material such as a polymer resin such as polyimide ("PI").

A buffer film BF may be disposed on one surface of the substrate SUB. The buffer film BF may be a film for preventing the penetration of air or moisture. The buffer film BF may include or consist of a plurality of inorganic films alternately laminated. In an embodiment, the buffer film BF may be formed as a multilayer of alternately stacked inorganic films of one or more of a silicon nitride layer, a silicon oxynitride layer, a silicon oxide layer, a titanium oxide layer, and an aluminum oxide layer. The buffer film BF may be omitted.

An active layer ACT may be disposed on the buffer film BF. The active layer ACT may include a silicon semiconductor, such as polycrystalline silicon, monocrystalline silicon, low-temperature polycrystalline silicon, and amorphous silicon, or may include an oxide semiconductor.

The active layer ACT may include a channel TCH, a first electrode TS, and a second electrode TD of a thin film transistor TFT. The channel TCH of the thin film transistor TFT may be an area overlapping with a gate electrode TG of the thin film transistor TFT in the third direction DR3 that is a thickness direction of the substrate SUB. The first electrode TS of the thin film transistor TFT may be disposed on one side of the channel TCH, and the second electrode TD may be disposed on an opposite side of the channel TCH. The first electrode TS and the second electrode TD of the thin film transistor TFT may be areas that do not overlap with the gate electrode TG in the third direction DR3. The first electrode TS and the second electrode TD of the thin film transistor TFT may be areas in which ions are doped in a silicon semiconductor or an oxide semiconductor to have conductivity.

A gate insulating film 130 may be disposed on the active layer ACT. The gate insulating film 130 may include or consist of an inorganic film, such as a silicon nitride layer, a silicon oxynitride layer, a silicon oxide layer, a titanium oxide layer, or an aluminum oxide layer.

A first gate layer GTL1 may be disposed on the gate insulating film 130. The first gate layer GTL1 may include the gate electrode TG of the thin film transistor TFT and the first capacitor electrode CAE1. The first gate layer GTL1 may be formed as a single layer or multiple layers of any one of molybdenum (Mo), aluminum (Al), chromium (Cr), gold (Au), titanium (Ti), nickel (Ni), neodymium (Nd), and copper (Cu), or any alloys thereof.

A first inter-insulating film 141 may be disposed on the first gate layer GTL1. The first inter-insulating film 141 may include or consist of an inorganic film, such as a silicon nitride layer, a silicon oxynitride layer, a silicon oxide layer, a titanium oxide layer, or an aluminum oxide layer.

A second gate layer GTL2 may be disposed on the first inter-insulating film 141. The second gate layer GTL2 may include a second capacitor electrode CAE2. The second gate layer GTL2 may be formed as a single layer or multiple layers of any one of molybdenum (Mo), aluminum (Al), chromium (Cr), gold (Au), titanium (Ti), nickel (Ni), neodymium (Nd), and copper (Cu), or any alloys thereof.

A second inter-insulating film 142 may be disposed on the second gate layer GTL2. The second inter-insulating film 142 may include or consist of an inorganic film, such as a silicon nitride layer, a silicon oxynitride layer, a silicon oxide layer, a titanium oxide layer, or an aluminum oxide layer.

A first data metal layer DTL1 including a first connection electrode CE1, a first sub-pad, and a data line may be disposed on the second inter-insulating film 142. The data line may be formed integrally with the first sub-pad, but embodiments of the disclosure are not limited thereto. The first data metal layer DTL1 may be formed as a single layer or multiple layers of any one of molybdenum (Mo), aluminum (Al), chromium (Cr), gold (Au), titanium (Ti), nickel (Ni), neodymium (Nd), and copper (Cu), or any alloys thereof.

A first connection electrode CE1 may be connected to the first electrode TS or the second electrode TD of the thin film transistor TFT through the first contact hole CT1 penetrating the first inter-insulating film 141 and the second inter-insulating film 142.

A first planarization film 160 may be disposed on the first data metal layer DTL1 to planarize the step caused by the active layer ACT, the first gate layer GTL1, the second gate layer GTL2, and the first data metal layer DTL1. The first planarization film 160 may be formed from an organic film such as an acrylic resin, an epoxy resin, a phenolic resin, a polyamide resin, a polyimide resin, or the like.

A second data metal layer DTL2 may be disposed on the first planarization film 160. The second data metal layer DTL2 may include a second connection electrode CE2 and a second sub pad. The second connection electrode CE2 may be connected to the first connection electrode CE1 through a second contact hole CT2 penetrating the first insulating film 161 and the first planarization film 160. The second data metal layer DTL2 may be formed as a single layer or multiple layers of any one of molybdenum (Mo), aluminum (Al), chromium (Cr), gold (Au), titanium (Ti), nickel (Ni), neodymium (Nd), and copper (Cu), or any alloys thereof.

A second planarization film 180 may be disposed on the second data metal layer DTL2. The second planarization film 180 may include or consist of an organic film, such as an acrylic resin, an epoxy resin, a phenolic resin, a polyamide resin, a polyimide resin, or the like.

A third data metal layer DTL3 may be disposed on the second planarization film 180. The third data metal layer DTL3 may include a third connection electrode CE3 and a third sub pad. The third connection electrode CE3 may be connected to the second connection electrode CE2 through a third contact hole CT3 penetrating the second insulating film 181 and the second planarization film 180. The third data metal layer DTL3 may be formed as a single layer or multiple layers of any one of molybdenum (Mo), aluminum (Al), chromium (Cr), gold (Au), titanium (Ti), nickel (Ni), neodymium (Nd), and copper (Cu), or any alloys thereof.

A third planarization film 190 may be disposed on the third data metal layer DTL3. The third planarization film 190 may include or consist of an organic film, such as an acrylic resin, an epoxy resin, a phenolic resin, a polyamide resin, a polyimide resin, or the like.

A fourth data metal layer DTL4 may be disposed on the third planarization film 190. The fourth data metal layer DTL4 may include an anode pad electrode APD, a cathode pad electrode CPD, and a fourth sub pad. The anode pad electrode APD may be connected to a third connection electrode CE3 through a fourth contact hole CT4 penetrating the third insulating film 191 and the third planarization film 190. The cathode pad electrode CPD may be supplied with a first power supply voltage that is a relatively low potential voltage. The fourth data metal layer DTL4 may be formed as a single layer or multiple layers of any one of molybdenum (Mo), aluminum (Al), chromium (Cr), gold (Au), titanium (Ti), nickel (Ni), neodymium (Nd), and copper (Cu), or any alloys thereof.

The light-emitting element LE is exemplified as a flip-chip type micro LED in which the first contact electrode CTE1 and the second contact electrode CTE2 are disposed to face the anode pad electrode APD and the cathode pad electrode CPD but is not limited thereto. The light-emitting element LE may be an inorganic light-emitting element including or consisting of an inorganic material such as GaN. The light-emitting element LE may have a length in the first direction DR1, a length in the second direction DR2, and a length in the third direction DR3 of several to several hundred micrometers (µm), respectively. In an embodiment, the light-emitting element LE may have a length in the first direction DR1, a length in the second direction DR2, and a length in the third direction DR3 of approximately 100 µm or less, respectively.

The light-emitting elements LE may be grown and formed on a semiconductor substrate such as a silicon wafer. Each of the light-emitting elements LE may be transferred directly from the silicon wafer onto the anode pad electrode APD and the cathode pad electrode CPD of the substrate SUB. In this case, the first contact electrode CTE1 and the anode pad electrode APD may be bonded to each other through a bonding process. Further, the second contact electrode CTE2 and the cathode pad electrode CPD may be bonded to each other through the bonding process. The first contact electrode CTE1 and the anode pad electrode APD may be electrically connected to each other through a bonding electrode 23. Furthermore, the second contact electrode CTE2 and the cathode pad electrode CPD may be electrically connected to each other through the bonding electrode 23.

In an embodiment, the bonding electrode 23 may be disposed on one side of the light-emitting element LE. The bonding electrode 23 may be a bonding product of pressurized melting bonding using a laser. Here, the pressurized melting bonding refers to a state in which the bonding electrode 23 is heated and melted, and the light-emitting element LE, the anode pad electrode APD, and the cathode pad electrode CPD are melted and mixed, and then cooled and solidified when the laser supply is terminated. Since the conductivity of the light-emitting element LE, the anode pad electrode APD, and the cathode pad electrode CPD is maintained while being cooled and solidified in a melted and mixed state, the anode pad electrode APD, the cathode pad electrode CPD, and the light-emitting element LE may be electrically connected and physically connected, respectively. Accordingly, the bonding electrode 23 may be disposed on the first contact electrode CTE1 and the second contact electrode CTE2 of the light-emitting element LE.

The bonding electrode 23 may include Au, AuSn, PdIn, InSn, NiSn, Au-Au, AgIn, AgSn, Al, Ag, or carbon nanotubes CNT, for example. Each of these may be used alone or in combination of two or more.

Each of the light-emitting elements LE may be a light-emitting structure including a base substrate SPUB, an n-type semiconductor NSEM, an active layer MQW, a p-type semiconductor PSEM, a first contact electrode CTE1, and a second contact electrode CTE2.

The base substrate SPUB may be a sapphire substrate, but the embodiments of the disclosure are not limited thereto.

The n-type semiconductor NSEM may be disposed on one surface of the base substrate SPUB. In an embodiment, the n-type semiconductor NSEM may be disposed on a bottom surface of the base substrate SPUB, for example. The n-type semiconductor NSEM may include or consist of GaN doped with n-type conductive dopants such as Si, Ge, Sn, or the like.

The active layer MQW may be disposed on a portion of one surface of the n-type semiconductor NSEM. The active layer MQW may include a material having a single or multiple quantum well structure. When the active layer MQW includes a material having a multi-quantum well structure, it may have a structure in which multiple well layers and barrier layers are alternately laminated. In this case, the well layers may include or consist of InGaN, and the barrier layers may include or consist of GaN or AlGaN but are not limited thereto. In an alternative embodiment, the active layer MQW may have a structure in which semiconductor materials having a relatively large band gap energy and semiconductor materials having a relatively small band gap energy are alternately laminated and may include different group III to group V semiconductor materials depending on the wavelength of the light emitted.

In an embodiment of the disclosure, a flip-chip type light-emitting element has been described in an embodiment, but it is not limited thereto and a vertical type light-emitting element may be used.

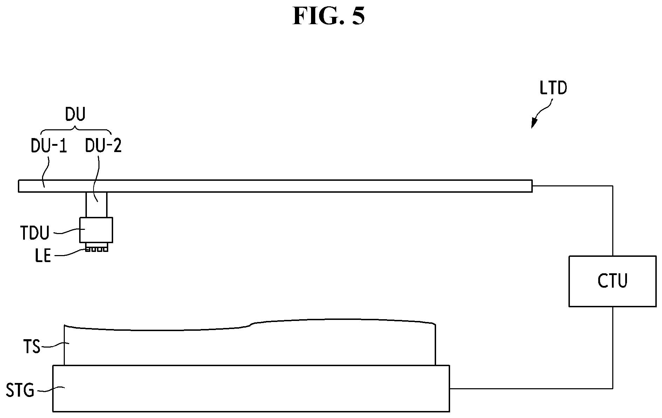

FIG. 5 is a schematic diagram schematically illustrating an embodiment of a light-emitting element transfer device LTD.

The light-emitting element transfer device LTD in an embodiment is a device used to transfer a light-emitting element.

As shown in FIG. 5, the light-emitting element transfer device LTD has a driving device DU, a transfer device TDU, a stage STG, and a controller CTU.

The driving device DU enables the transfer device TDU to move up, down, left, and right. The driving device DU may include an XY driving unit DU-1 and a Z driving unit DU-2.

The XY driving unit DU-1 moves the transfer device TDU above the stage STG on which the light-emitting element LE is placed.

The Z driving unit DU-2 lowers the transfer device TDU to approach a predetermined distance from the light-emitting element LE to be picked up.

The transfer device TDU is a device for picking up the light-emitting element LE.

The transfer device TDU may include one of an electrostatic chuck, an adhesive chuck, a vacuum chuck, or a porous vacuum chuck, for example. The transfer device TDU may lift the light-emitting element LE by sucking it using the chuck. In an embodiment, an embodiment of transferring the light-emitting element LE to the substrate TS is shown, but it is not limited thereto, and may be applied to soy flip chip mounting in which a flip chip is connected to a bump arranged in an array shape on the substrate TS, and may also be applied to so-called die bonding in which the light-emitting element LE is bonded to the substrate TS.

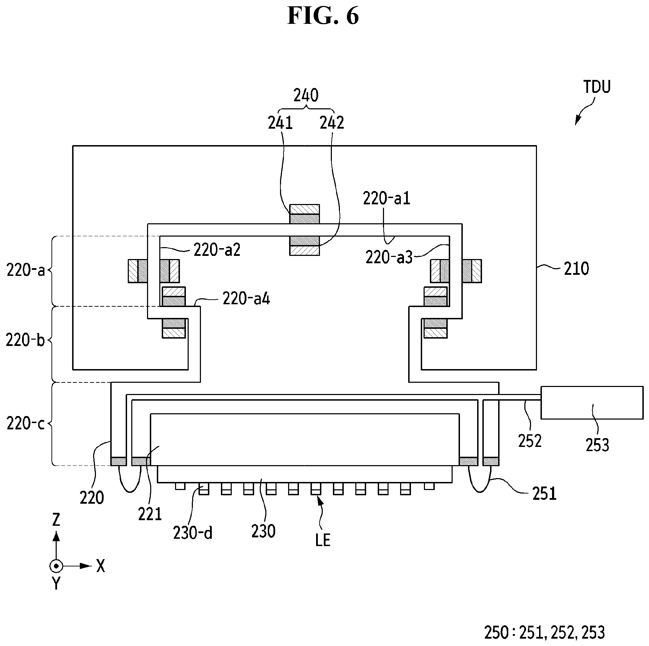

The structure of the transfer device TDU will be described in detail with reference to FIG. 6.

The stage STG supports the substrate TS. The stage STG may be installed at the center of the XY driving unit DU-1 based on the base. The stage STG may be installed to be movable in the Y direction but is not limited thereto.

The controller CTU is connected to the driving device DU and the transfer device TDU and perform processing desired for transfer by controlling the operation of these components by the controller CTU. The controller CTU is provided with an interface (not shown) that transmits and receives signals between the above-described components, such as the driving device DU and the transfer device TDU, for example. The controller CTU feed back the processing for the above-described bonding based on the detection result of a camera or sensor, etc. In an embodiment, the controller CTU recognizes the alignment key of the light-emitting element LE substrate TS based on an image taken by a camera, detects a position, and controls the XY driving unit DU-1 and the Z driving unit DU-2 based on the detection result to perform control related to a transfer operation of aligning the position of the light-emitting element LE, for example.

Next, the configuration of the above-described transfer device TDU will be described.

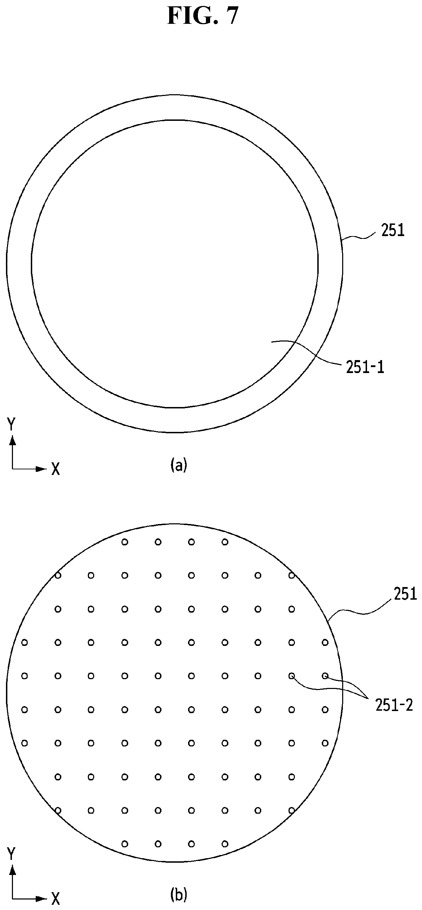

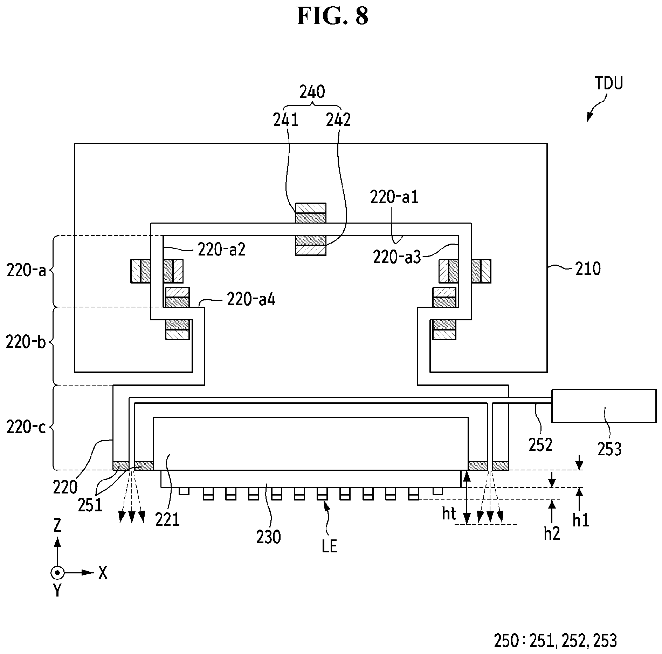

FIG. 6 is a schematic diagram schematically illustrating an embodiment of a transfer device. FIGS. 7 is a plan view of a spray head. FIG. 8 a drawing to illustrate an operation of the air spray member in FIG. 7.

Referring to FIG. 6, the transfer device TDU may include a first transfer head 210, a second transfer head 220, a stamp 230, a tilting adjustment member 240, an air spray member (also referred to as an air supply member) 250, a spray line 252, and an air supply unit (also referred to as an air supply portion) 253.

The first transfer head 210 is connected to the Z driving unit DU-2 and is intended to support the second transfer head 220.

The first transfer head 210 has a cavity defining an opening in the first direction. The width of the opening may be smaller than the width of the cavity.

The second transfer head 220 may be disposed below the first transfer head 210.

The second transfer head 220 may be divided into a first portion 220-a, a second portion 220-b, and a third portion 220-c. The first portion 220-a is disposed within the cavity of the first transfer head 210, the third portion 220-c is disposed outside the first transfer head 210, and the second portion 220-b is disposed between the first portion 220-a and the third portion 220-c. The second portion 220-b may be disposed at the opening of the cavity.

The second portion 220-b may be formed with a narrower width than the first portion 220-a and the third portion 220-c, so that the first portion 220-a may be caught in the cavity of the first transfer head 210. The first portion 220-a may have a shape that follows the shape of the cavity of the first transfer head 210. In an embodiment, when the cavity is quadrangular, e.g., rectangular, the first portion 220-a may also have a quadrangular shape, e.g., rectangular shape, for example.

The second transfer head 220 may include a chuck 221 on one side that is one of an electrostatic chuck, a tacky chuck, a vacuum chuck, or a porous vacuum chuck. In an embodiment, the chuck 221 may be disposed on one side of the third portion 220-c, for example. The stamp 230 may be adsorbed on one side of the second transfer head 220 by the chuck 221.

The stamp 230 may be disposed on a lower portion of the second transfer head 220.

The stamp 230 may include a plurality of layers. In an embodiment, the stamp 230 may include a base layer and a stamp layer, for example.

The base layer may support the stamp layer. The base layer may include or consist of, e.g., polyethylene terephthalate ("PET"), polyurethane (PU), polyimide ("PI"), polycarbonate ("PC"), polyethylene ("PE"), polypropylene ("PP"), polysulfone ("PSF"), polymethylmethacrylate ("PMMA"), triacetylcellulose ("TAC"), cycloolefin polymer ("COP"), or the like.

The stamp layer is disposed on one side of the base layer. The stamp layer includes a plurality of protrusions 230-d and may adhere or bond the light-emitting element LE. The stamp layer may include or consist of an adhesive or adhesive material, and the adhesive material includes, e.g., an optical clear adhesive ("OCA"), a pressure sensitive adhesive ("PSA"), or the like, and the tacky material may include an acrylic-based, urethane-based, or silicone-based adhesive material, for example. One end of the plurality of protrusions is flat, and the shape of the protrusions may be a polygonal column or a cylinder.

The tilting adjustment member 240 may adjust the relative flatness between the stamp 230 and the substrate TS by adjusting the tilting of the second transfer head 220.

The tilting adjustment member 240 may include a plurality of permanent magnets. The tilting adjustment member 240 is formed by a plurality of pairs of permanent magnets. A pair of permanent magnets may include a plurality of first permanent magnets 241 and a plurality of second permanent magnets 242. The plurality of first permanent magnets 241 may be attached to the first transfer head 210. The plurality of second permanent magnets 242 may be attached to the second transfer head 220. In an embodiment, the plurality of second permanent magnets 242 may be attached to a first surface 220-a1, a second surface 220-a2, a third surface 220-a3, and a fourth surface 220a-4 of the first portion 220-a of the second transfer head 220, for example. The plurality of first permanent magnets 241 may be disposed to face the pair of second permanent magnets 242 within the cavity of the first transfer head 210. The number of the first permanent magnets 241 and the number of the second permanent magnets 242 are the same.

Therefore, the first permanent magnets 241 and the second permanent magnets 242 are disposed to face each other. Further, the first permanent magnets 241 and the second permanent magnets 242 are disposed to face each other with the same polarity. In an embodiment, the S-polar magnetic pole of the first permanent magnet 241 and the S-polar magnetic pole of the second permanent magnet 242 face each other, for example. The magnetic force between the opposing magnetic poles of the first permanent magnet 241 and the second permanent magnet 242 is balanced, so that the first permanent magnet 241 and the second permanent magnet 242 are not in contact with each other and the second transfer head 220 floats.

In FIG. 6, a total of five pairs of the first permanent magnet 241 and the second permanent magnet 242 are disposed, but the number or positions of the first permanent magnet 241 and the second permanent magnet 242 is not limited thereto.

In addition, the magnetic force between the first permanent magnet 241 and the second permanent magnet 242 serves to return the second transfer head 220 to its original position when the external force is removed, even when the second transfer head 220 is tilted by an external force.

Since the second transfer head 220 floats due to the repulsive force of the first permanent magnet 241 and the second permanent magnet 242, the first transfer head 210 may not tilt even when the second transfer head 220 tilts. Conversely, the second transfer head 220 may tilt depending on the flatness of the substrate disposed underneath.

The air spray member 250 forms an air layer by injecting air downward from one side of the second transfer head 220.

In an embodiment, the spray head 251, the spray line 252, and the air supply unit 253 may be included, and air injected from the air supply unit 253 may be discharged through the spray head 251 along the spray line 252, for example.

The spray head 251 may be disposed around the stamp 230 on one side of the second transfer head 220. Since air is discharged downward (e.g., toward the substrate TS) from the spray head 251, an air layer may be formed between the spray head 251 and the substrate TS. The thickness of the air layer may be adjusted by the air discharge amount of the air supply unit 253 and may be formed to a thickness at least such that the light-emitting element LE attached to the stamp 230 does not contact the substrate TS.

The spray head 251 may be formed as a hole type so that the injected air is evenly sprayed but is not limited thereto. As an embodiment of the hole type structure, it may be formed as a single hole 251-1 as shown in (a) of FIG. 7 or may be formed as a porous type having a plurality of pores 251-2 on a predetermined plane as shown in (b) of FIG. 7 so that gas is evenly sprayed over the entirety of the plane. The shape of the hole in the plan view may include a circular, square, etc. but is not limited thereto.

In this specification, "in the plan view" is set based in a plan view parallel to the plane defined by the first direction DR1 and the second direction DR2. In this specification, "in the cross-section" is defined as a state viewed from the first direction DR1 or the second direction DR2.

In addition, the spray head 251 may be formed in a shape in which the width is narrowed downward in the cross-section to increase the efficiency of spraying air downward. In an alternative embodiment, the spray head 251 may be formed in a shape that widens downward.

The spray line 252 is a pipe that supplies gas to the spray head 251 and may penetrate a portion of the second transfer head 220.

As shown in FIG. 8, the air supply unit 253 continuously ejects air from the spray head 251 through the spray line 252 for a predetermined duration. The duration may be the time until the light-emitting element LE disposed on one side of the stamp 230 is transferred to the substrate TS.

When air is ejected downward from the spray head 251, the second transfer head 220 is pushed up in the opposite direction to the direction of movement of the air by the pressure of the ejected air. As a result, the second transfer head 220 may be in a floating state separated from the substrate TS by a first distance ht. The first distance ht may be longer than the sum of the height h1 of the stamp 230 in the third direction and the height h2 of the light-emitting element LE, as described below.

The air supply unit 253 may supply air. In an embodiment, the air supply unit 253 may be an air pump, for example, but is not limited thereto. In an embodiment, the air supply unit 253 may supply an inert or chemically unresponsive gas, such as nitrogen (N2), helium (He), neon (Ne), argon (Ar), carbon dioxide (CO₂), or any combinations thereof, for example.

The air supply unit 253 may further include a reservoir for storing air (or gas), and a valve for controlling the flow of the air (or gas). Further, the air supply unit 253 may eject air to the spray head 251 through the spray line 252.

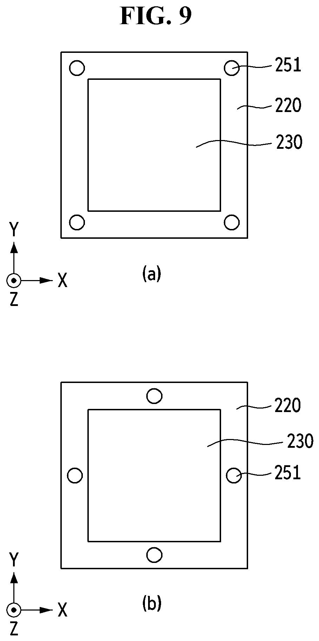

FIGS. 9 to 12 are plan views to illustrate the number and shape of a buffer member.

As may be seen from FIGS. 9 to 12, the number and shape of the spray heads may be modified in various ways.

Referring to FIGS. 9 to 12, the stamp 230 may follow the shape of the second transfer head 220 in a plan view. In an embodiment, when the second transfer head 220 has a square shape in a plan view, the shape of the stamp 230 in a plan view may also be a square, for example, but is not limited thereto. In an embodiment, the second transfer head 220 and the stamp 230 may be circular, for example. In this specification, "in a plan view" is set based in a plan view parallel to a plane defined by the first direction DR1 and the second direction DR2. In this specification, "in a cross-section" is defined as a state viewed from the first direction DR1 or the second direction DR2.

The spray head 251 may be disposed around the stamp 230 on one side of the second transfer head 220. The spray head 251 does not overlap the stamp 230 in a plan view.

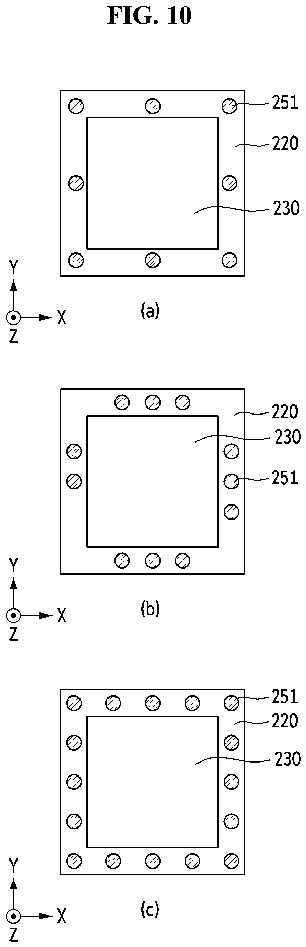

Referring to FIGS. 9 and 10, a plurality of spray heads may be circular.

In an embodiment, referring to (a) of FIG. 9, the plurality of spray heads 251 may be disposed at each of the four corners of the second transfer head 220, for example.

In addition, referring to (b) of FIG. 9, the plurality of spray heads 251 may be disposed at each of the centers of each side of the second transfer head 220.

Also, referring to (a) of FIG. 10, the plurality of spray heads 251 may be disposed at each of the four corners and each center of each side of the second transfer head 220.

In addition, referring to (b) of FIG. 10, the plurality of spray heads 251 may be disposed at each side of the second transfer head 220 except for the four corners of the second transfer head 220. In an embodiment, three spray heads 251 may be disposed at each side, for example, but the number of spray heads 251 is not limited thereto.

Also, referring to (c) of FIG. 10, the plurality of spray heads 251 may be disposed at the four corners of the second transfer head 220 and each side of the second transfer head 220. Each spray head 251 may be spaced apart from each other at the same interval but is not limited thereto.

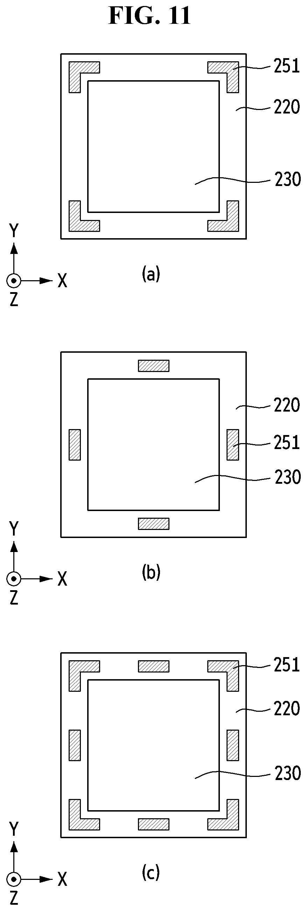

Referring to FIG. 11, a plurality of spray heads 251 may be polygons having corners.

Referring to (a) of FIG. 11, the plurality of spray heads 251 may be disposed at four corners of the second transfer head 220 to surround the corners of the stamp 230 without overlapping the stamp 230 and spaced apart from the stamp 230. In an embodiment, the spray heads 251 may have an " 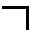 " or " 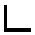 " shape, for example.

Referring to (b) of FIG. 11, the plurality of spray heads 251 may be disposed at the center of each side of the second transfer head 220 in a square shape.

Referring to (c) of FIG. 11, the plurality of spray heads 251 may have different shapes. In an embodiment, the plurality of spray heads 251 may be disposed at four corners of the second transfer head 220 to surround the corners of the stamp 230 and may further be disposed at the center of each side of the square shape of the second transfer head 220, for example.

Referring to FIGS. 9 and 11, the spray heads 251 may be disposed discontinuously around the stamp 230.

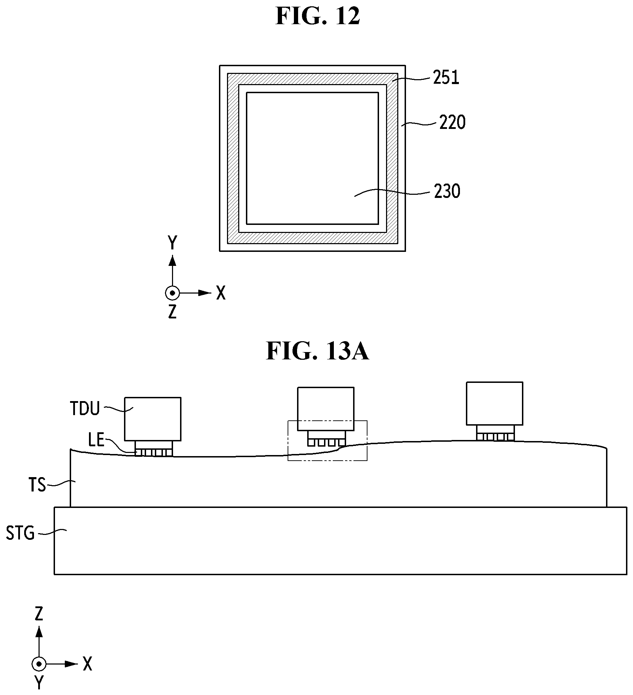

Referring to FIG. 12, the spray heads 251 may be disposed continuously around the stamp 230. In an embodiment, the spray heads 251 may be a single square shape surrounding the stamp 230 in the second transfer head 220, for example.

As may be seen from FIGS. 9 and 12, the number and shape of the buffer members may be variously modified.

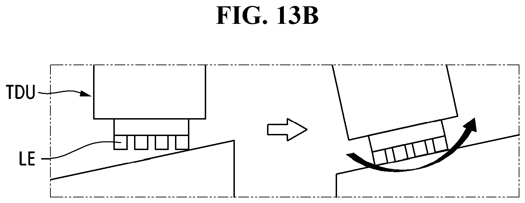

FIG. 13A is a drawing to illustrate the operation of a light-emitting element transfer device without a tilting adjustment member and a buffer member, and FIG. 13B is an enlarged view of a dot-dashed portion of FIG. 13A.

In the case of the light-emitting element transfer device that does not include a tilting adjustment member (240 of FIG. 6) and the buffer member (250 of FIG. 6), the light-emitting elements LE attached to the stamp 230 may rotate after the surface of the substrate TS is touched by the bending or tilting of the substrate TS. Accordingly, a change in the planar direction position of the light-emitting elements LE occurs due to the rotation of the stamp 230. In an embodiment, when the height decreases from one end of the substrate TS to an opposite end, the light-emitting elements LE first touch the end of the substrate TS that has a higher height, for example. There is a concern that the light-emitting element LE that touches the surface of the substrate TS first may fall over or become misaligned due to a force applied in the planar direction on the surface of the substrate TS. Since bending or tilting of the substrate TS frequently occurs, especially in the case of a large-area substrate TS, this problem is more serious.

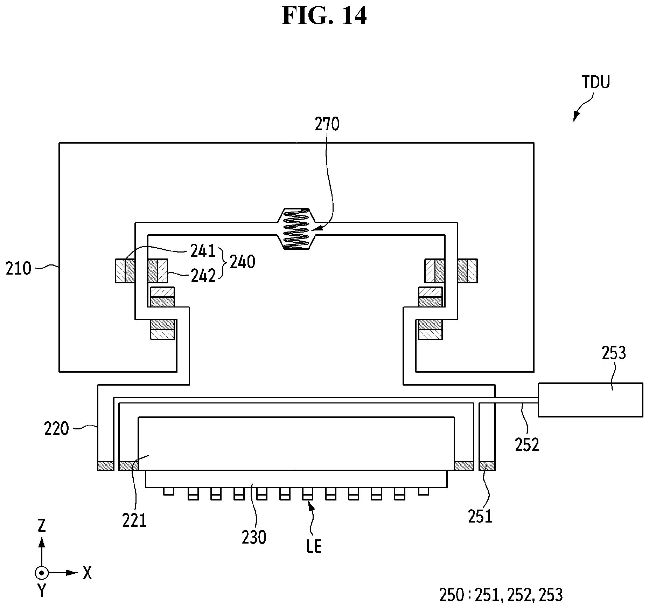

FIG. 14 is a schematic diagram schematically illustrating another embodiment of a transfer mechanism of a light-emitting element.

Referring to FIG. 14, it is different from FIG. 6 in that a pressure member 270 is included instead of a pair of permanent magnets between the first transfer head 210 and the second transfer head 220. The description given above with reference to FIGS. 6 to 12 may be equally applied to the configuration other than the pressure member 270, and the following description will focus on the pressure member 270.

The pressure member 270 is disposed in the cavity of the first transfer head 210 and is disposed between the first transfer head 210 and the second transfer head 220, so that the second transfer head 220 may be pressurized while maintaining the space between the first transfer head 210 and the second transfer head 220.

In addition, the pressure member 270 may include a spring, for example, but is not limited thereto. When the pressure member 270 is formed as a spring, it may prevent a sudden transfer of pressure when applying a pressure force from the top to the bottom of the first transfer head 210.

In an embodiment, it is exemplified that one pressure member 270 is disposed between the first transfer head 210 and the second transfer head 220, but the number of pressure members 270 is not limited. In an embodiment, a plurality of springs may be disposed between the first transfer head 210 and the second transfer head 220.

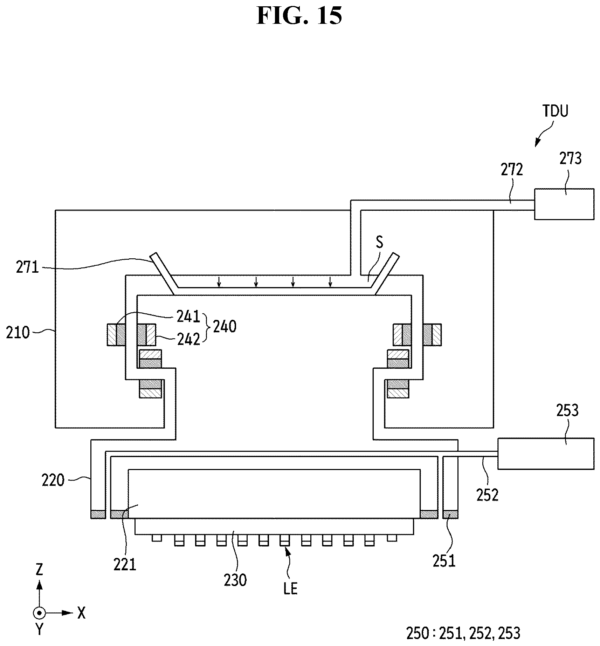

FIG. 15 a schematic diagram schematically illustrating another embodiment of a transfer mechanism of a light-emitting element.

Referring to FIG. 15, it is different from FIG. 6 in that a pressure member 270 is included between the first transfer head 210 and the second transfer head 220. The description given above with reference to FIGS. 6 to 12 may be equally applied to the configuration other than the pressure member 270, and the following description will focus on the pressure member 270.

In an embodiment, the pressure member 270 may include an elastic film 271, a gas pipe 272, and a gas supply member 273.

The elastic film 271 includes or consists of an elastic material such as an elastomer. It may be disposed in the cavity of the first transfer head 210 and between the first transfer head 210 and the second transfer head 220, so that a space S may be formed between the elastic film 271 and the first transfer head 210. The pressure member 270 may maintain the space between the first transfer head 210 and the second transfer head 220.

The gas pipe 272 may supply gas to the space S between the elastic film 271 and the first transfer head 210 to expand the elastic film 271 downward. When the elastic film 271 expands, the second transfer head 220 is pressurized.

The gas supply member 273 supplies gas to the space S through the gas pipe 272. The gas supply member 273 controls the expansion force of the elastic film 271, thereby ultimately controlling the pressurizing force to the second transfer head 220.

The gas supply member 273 may supply an inert or extremely relatively low chemically reactive gas, such as nitrogen (N2), helium (He), neon (Ne), argon (Ar),, carbon dioxide (CO₂), or any combinations thereof, to the internal space. Hereinafter, such inert or extremely relatively low chemically reactive gases are collectively referred to as neutral gas.

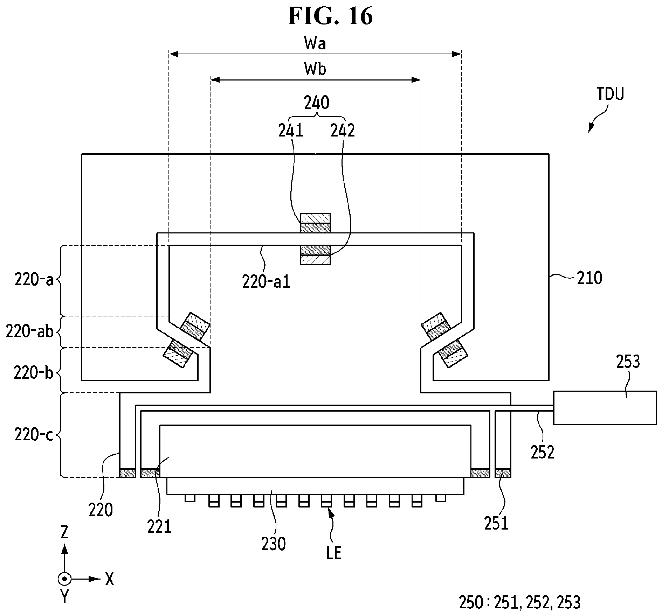

FIG. 16 a schematic diagram schematically illustrating another embodiment of a transfer mechanism of a light-emitting element.

Referring to FIG. 16, the second transfer head 220 is different from FIG. 6 in that it further includes an inclined portion 220-ab between the first portion 220-a and the second portion 220-b, and the number of tilting adjustment members 240 is smaller compared to FIG. 6.

The inclined portion 220-ab is disposed between the first portion 220-a having a first width Wa and the second portion 220-b having a second width Wb and connects one end of the first portion 220-a and one end of the second portion 220-b, and has an inclination angle with a side parallel to the first side 220-a1 of the first portion 220-a.

The tilting adjustment member 240 may be disposed on the first surface 220-a1 and the inclined portion 220-ab of the second transfer head 220 and may include a total of three pairs of permanent magnets. Each pair of permanent magnets may include a plurality of first permanent magnets 241 and a plurality of second permanent magnets 242.

The plurality of first permanent magnets 241 may be attached to the first transfer head 210. The plurality of second permanent magnets 242 may be attached to the second transfer head 220. In an embodiment, the plurality of second permanent magnets 242 may be attached to a first surface 220-a1 of a first portion 220-a of the second transfer head 220, a second surface 220-a2 of an inclined portion 220-ab of the second transfer head 220, and a third surface 220-a3 of a second portion 220-b of the second transfer head 220, for example. The plurality of first permanent magnets 241 may be disposed to face a pair of second permanent magnets 242 within the cavity of the first transfer head 210. The number of first permanent magnets 241 and the number of second permanent magnets 242 may be equal.

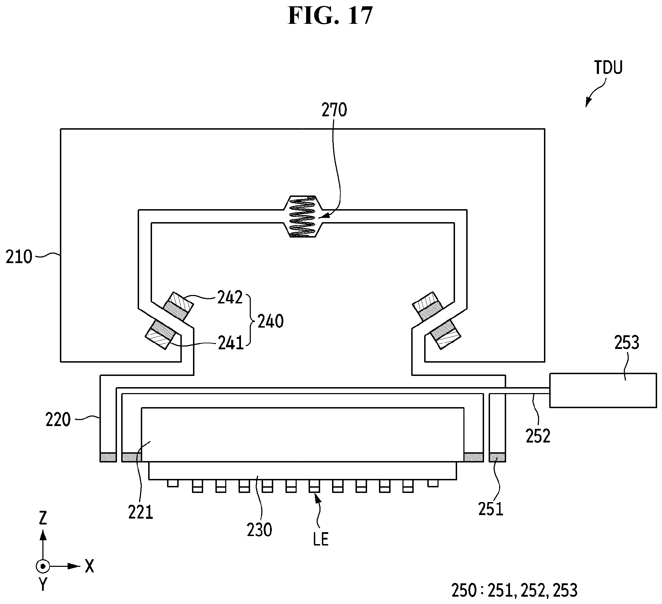

FIG. 17 a schematic diagram schematically illustrating another embodiment of a transfer mechanism of a light-emitting element.

Referring to FIG. 17, it is different from FIG. 16 in that a pressure member 270 is included instead of a pair of permanent magnets between the first transfer head 210 and the second transfer head 220. The description described above in FIG. 14 may be applied equally to the configuration other than the pressure member 270, and the following description will focus on the pressure member 270.

The pressure member 270 may be disposed in the cavity of the first transfer head 210 and may be disposed between the first transfer head 210 and the second transfer head 220. In an embodiment, it may be disposed between the first surface 220-a1 of the first portion 220-a of the second transfer head 220 and the first transfer head 210 in the cavity of the first transfer head 210, for example. Accordingly, the second transfer head 220 may be pressurized while maintaining the space between the first transfer head 210 and the second transfer head 220.

In addition, the pressure member 270 may include a spring, for example, but is not limited thereto. When the pressure member 270 is formed as a spring and a pressurizing force is applied from the top side to the bottom side of the first transfer head 210 a sudden transfer of pressure may be prevented.

In an embodiment, it is exemplified that one pressure member 270 is disposed between the first transfer head 210 and the second transfer head 220, but the number of pressure member 270 is not limited. In an embodiment, a plurality of springs may be disposed between the first transfer head 210 and the second transfer head 220, for example.

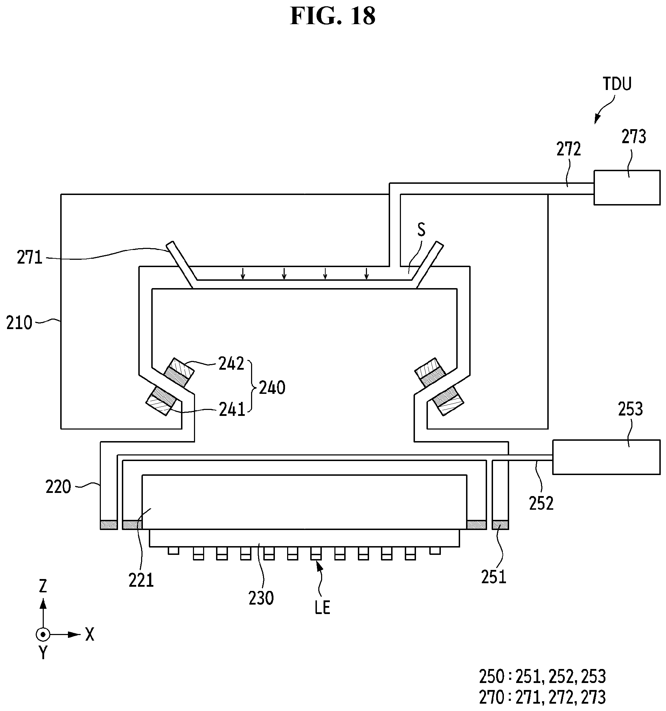

FIG. 18 a schematic diagram schematically illustrating another embodiment of a transfer mechanism of a light-emitting element.

Referring to FIG. 18, it is different from FIG. 16 in that a pressure member 270 is included instead of a pair of permanent magnets between the first transfer head 210 and the second transfer head 220. The description described above in FIG. 16 may be applied equally to the configuration other than the pressure member 270, and the following description will focus on the pressure member 270.

In an embodiment, the pressure member 270 may include an elastic film 271, a gas pipe 272, and a gas supply member 273.

The elastic film 271 includes or consists of an elastic material such as an elastomer. It may be disposed in the cavity of the first transfer head 210 and between the first transfer head 210 and the second transfer head 220, so that a space S may be formed between the elastic film 271 and the first transfer head 210. The pressure member 270 may maintain the space between the first transfer head 210 and the second transfer head 220.

The gas pipe 272 may supply gas to the space S between the elastic film 271 and the first transfer head 210 to expand the elastic film 271 downward. When the elastic film 271 expands, the second transfer head 220 is pressurized.

The gas supply member 273 supplies gas to the space S through the gas pipe 272.

The gas supply member 273 may supply an inert or extremely relatively low chemically reactive gas, such as nitrogen (N2), helium (He), neon (Ne), argon (Ar), carbon dioxide (CO₂), or any combinations thereof, to the internal space. Hereinafter, such inert or extremely relatively low chemically reactive gases are collectively referred to as neutral gas.

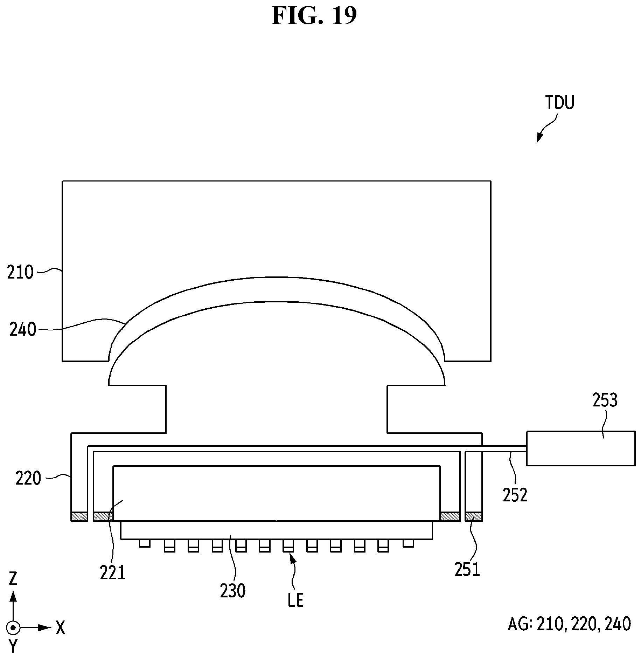

FIG. 19 a schematic diagram schematically illustrating another embodiment of a transfer mechanism of a light-emitting element.

Referring to FIG. 19, the first transfer head 210, the second transfer head 220, and the tilting adjustment member 240 include or consist of an air gyro AG and may be different from FIG. 6 in that they do not include a permanent magnet.

The air gyro AG may adjust the relative flatness between the stamp 230 and the substrate TS instead of the permanent magnet of FIG. 6. The relative flatness between the stamp 230 and the substrate TS may be adjusted more precisely through the air gyro AG.

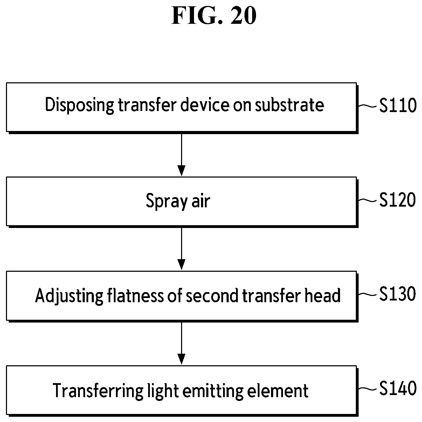

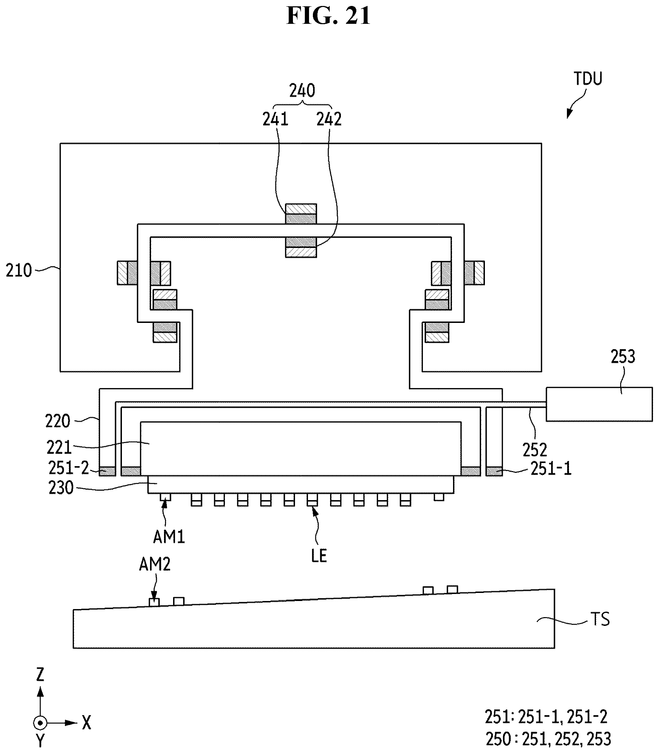

FIG. 20 is a flow chart illustrating a light-emitting element transfer method. FIGS. 21 to 25 are cross-sectional views to illustrate a light-emitting element transfer method. FIGS. 20 to 25 illustrate cross-sectional views of a structure of a transfer device according to the transfer order of the light-emitting element. FIGS. 21 to 25 mainly illustrate a transfer device TDU and a light-emitting element LE, which may generally correspond to a cross-sectional view or a plan view of the transfer device TDU described with reference to FIGS. 6 to 12, respectively. In the following, a light-emitting element transfer method illustrated in FIGS. 21 to 25 will be described in connection with FIG. 20.

First, the transfer device TDU is disposed on the substrate TS (S110 in FIG. 20).

Referring to FIG. 21, a light-emitting element LE and a first alignment key AM1 may be attached to the stamp 230 of the transfer device TDU.

A second alignment key AM2 may be disposed on the substrate TS.

The first alignment key AM1 and the second alignment key AM2 may be formed through a photolithography process.

As described in FIG. 5, the transfer device TDU may be disposed at a desired position by the XY driving unit DU-1 and the Z driving unit DU-2 of the light-emitting element transfer device LTD.

In an embodiment, the transfer device TDU may place the stamp 230 on the substrate TS by checking the relative positions of the first alignment key AM1 and the second alignment key AM2 disposed on the stamp 230, for example. In an embodiment, two second alignment key AM2 are disposed on the substrate TS, and the stamp 230 is disposed on the substrate TS such that the first alignment key AM1 faces the second alignment key AM2, for example. By adjusting the position of the transfer device TDU such that the first alignment key AM1 is disposed between the plurality of second alignment keys AM2, the light-emitting element LE may be disposed on the substrate TS at a desired position.

Second, the air spray member 250 ejects air and lowers the transfer device TDU (S120 in FIG. 20).

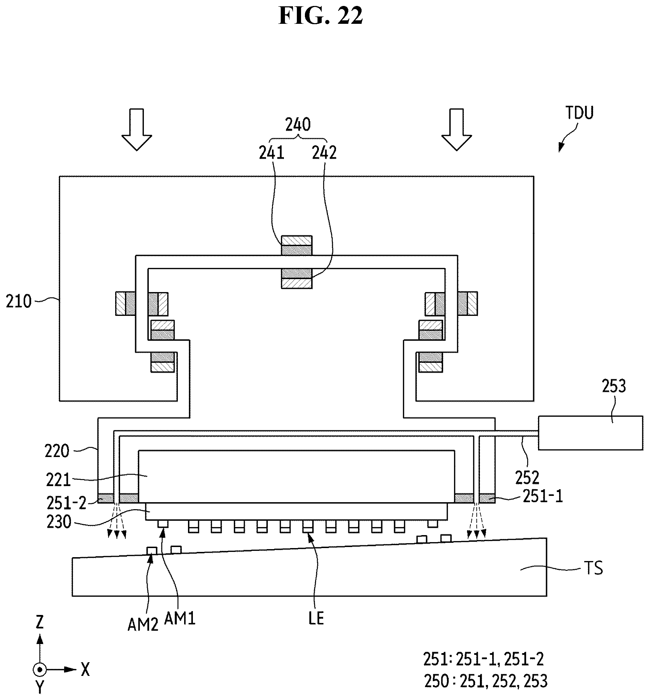

In an embodiment, as shown in FIG. 22, air is ejected from the spray head 251 and the transfer device TDU is pressurized downward, for example.

The air supply unit 253 supplies air to the spray head 251 along the spray line so that the spray head 251 ejects air in a downward direction (e.g., toward the substrate TS). As the air is ejected from the spray head 251, an air layer may be formed under the spray head 251. The force of the second transfer head 220 pushing the substrate TS may be generated by this air layer. When the force of the air ejection is in balance with the pressurizing force of the transfer device TDU, a constant distance between the substrate TS and the light-emitting element LE may be maintained. The constant distance may be adjusted by the air spray amount of the air supply unit 253. In addition, when the constant distance is greater than the sum of the height of the light-emitting element LE and the height of the stamp 230, the light-emitting element LE may not directly contact the substrate TS. The second transfer head 220 is in a non-contact state with the substrate TS, but the force of the air spray may support the second transfer head 220.

As described above, the second transfer head 220 generates a magnetic force between the first transfer head 210 and the second transfer head 220 by the tilting adjustment member 240. That is, even when a constant pressing force is applied from above, the second transfer head 220 may maintain a floating state by the magnetic force of the tilting adjustment member 240 and the spray amount of the air spray member 250.

Third, the flatness of the second transfer head 220 is adjusted to the flatness of the substrate TS by the tilting adjustment member 240 (S130 in FIG. 20).

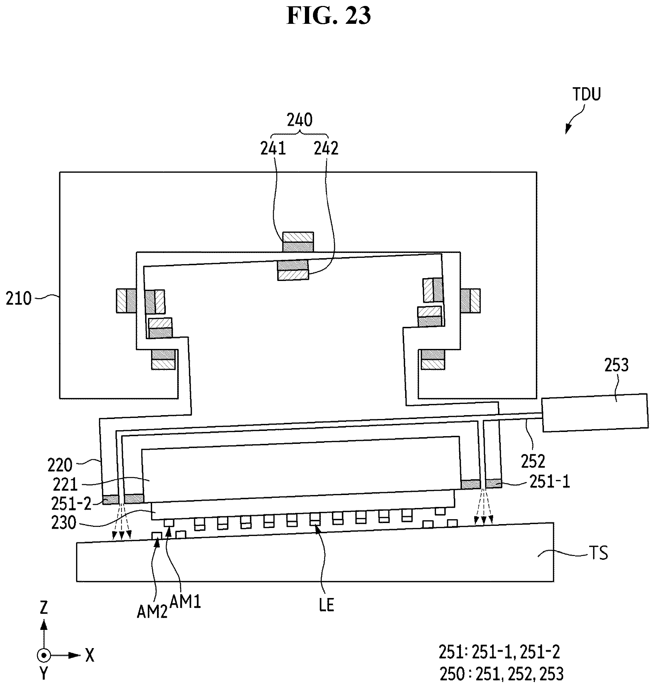

In an embodiment, as shown in FIG. 23, for example, the second transfer head 220 is floated and supported by an air layer formed under the spray head 251, and the light-emitting element LE is in a non-contact state with the substrate TS, and the movement of the second transfer head 220 may be adjusted so that the flatness of the second transfer head 220 is the same as the flatness of the substrate TS, for example.

Therefore, the alignment of the light-emitting element LE is not disturbed while adjusting the relative flatness of the second transfer head 220 and the substrate TS.

Fourth, the second transfer head 220 is pressurized and the light-emitting element LE is transferred.(S140 in FIG. 20).

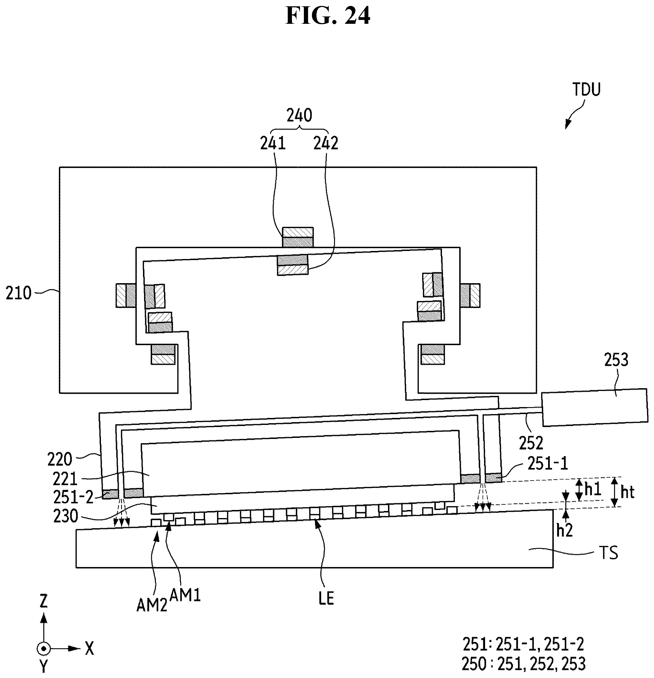

In an embodiment, as shown in FIG. 24, the second transfer head 220 may be further lowered downward to pressurize the air layer to contact the light-emitting element LE with the substrate TS, for example. As a result, the thickness of the air layer may be reduced, so that the light-emitting element LE may be contacted with the substrate TS. At this time, the thickness (or height) ht of the air layer may be equal to the sum of the height h2 of the light-emitting element LE in the third direction and the height h1 of the substrate.

The air spray member 250 may control the spray amount to limit the lowering position of the light-emitting element LE. In an embodiment, the air spray member 250 may prevent excessive lowering of the second transfer head 220 by limiting the minimum spray amount, for example. Since the lowering position is limited by the air spray member 250, the problem of damage to the light-emitting element LE may not be caused.

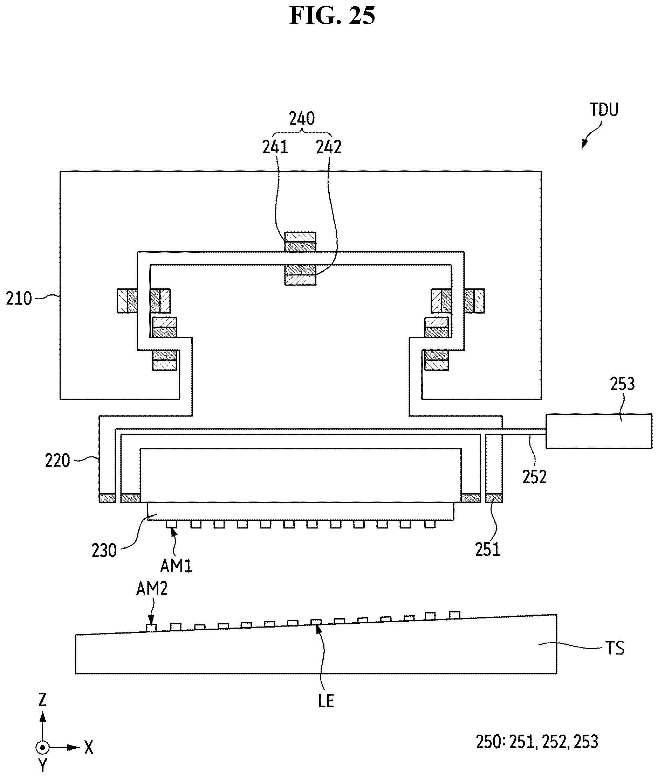

Next, referring to FIG. 25, the transfer device TDU may be lifted to separate the light-emitting element LE from the stamp 230.

A conventionally known technique such as a laser irradiation method may be applied to separate the stamp 230 and the light-emitting element LE.

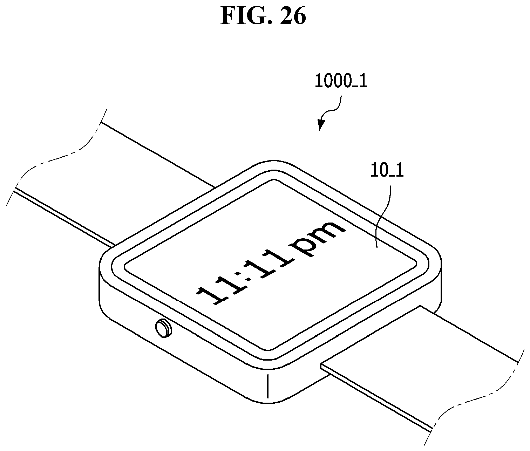

FIG. 26 is a perspective view of a smart watch including a display device.

Referring to FIG. 26, a display device 10_1 in an embodiment may be applied to a smart watch 1000_1 which is one of smart devices.

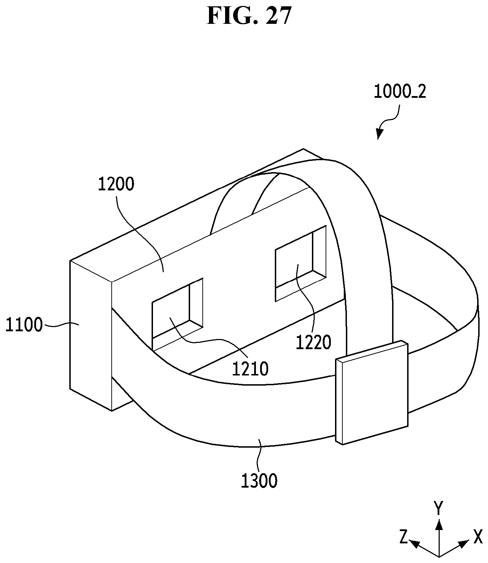

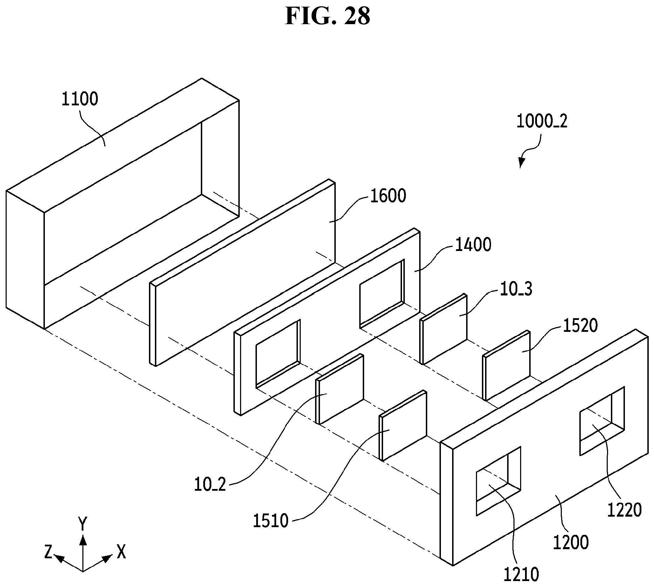

FIGS. 27 and 28 are perspective views of a virtual reality ("VR") device including a display device.

Referring to FIGS. 27 and 28, a head mounted display device 1000_2 in an embodiment includes a first display device 10_2, a second display device 10_3, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 10_2 provides an image to a user's left eye, and the second display device 10_3 provides an image to the user's right eye. Each of the first display device 10_2 and the second display device 10_3 is substantially the same as the display device 10 described with reference to FIGS. 1 and 2. Therefore, a description of the first display device 10_2 and the second display device 10_3 will be omitted.

The first optical member 1510 may be disposed between the first display device 10_2 and the first eyepiece 1210. The second optical member 1520 may be disposed between the second display device 10_3 and the second eyepiece 1220. Each of the first optical member 1510 and the second optical member 1520 may include at least one convex lens.

The middle frame 1400 may be disposed between the first display device 10_2 and the control circuit board 1600 and may be disposed between the second display device 10_3 and the control circuit board 1600. The middle frame 1400 supports and fixes the first display device 10_2, the second display device 10_3, and the control circuit board 1600.

The control circuit board 1600 may be disposed between the middle frame 1400 and the display device housing 1100. The control circuit board 1600 may be connected to the first display device 10_2 and the second display device 10_3 through a connector. The control circuit board 1600 may convert an image source received from the outside into digital video data and transmit the digital video data to the first display device 10_2 and the second display device 10_3 through the connector.

The control circuit board 1600 may transmit the digital video data corresponding to a left image optimized for a user's left eye to the first display device 10_2 and transmit the digital video data corresponding to a right image optimized for the user's right eye to the second display device 10_3. In an alternative embodiment, the control circuit board 1600 may transmit the same digital video data to the first display device 10_2 and the second display device 10_3.

The display device housing 1100 houses the first display device 10_2, the second display device 10_3, the middle frame 1400, the first optical member 1510, the second optical member 1520, and the control circuit board 1600. The housing cover 1200 is placed to cover an open surface of the display device housing 1100. The housing cover 1200 may include the first eyepiece 1210 on which a user's left eye is placed and the second eyepiece 1220 on which the user's right eye is placed. Although the first eyepiece 1210 and the second eyepiece 1220 are disposed separately in FIGS. 27 and 28, embodiments of the specification are not limited thereto. The first eyepiece 1210 and the second eyepiece 1220 may also be combined into one.

The first eyepiece 1210 may be aligned with the first display device 10_2 and the first optical member 1510, and the second eyepiece 1220 may be aligned with the second display device 10_3 and the second optical member 1520. Therefore, a user may view an image of the first display device 10_2, which is enlarged as a virtual image by the first optical member 1510, through the first eyepiece 1210 and may view an image of the second display device 10_3, which is enlarged as a virtual image by the second optical member 1520, through the second eyepiece 1220.

The head mounted band 1300 fixes the display device housing 1100 to a user's head so that the first eyepiece 1210 and the second eyepiece 1220 of the housing cover 1200 are kept placed on the user's left and right eyes, respectively. When the display device housing 1200 is implemented to be lightweight and small, the head mounted display device 1000_2 may include an eyeglass frame as illustrated in FIG. 33 instead of the head mounted band 1300.

In addition, the head mounted display device 1000_2 may further include a battery for supplying power, an external memory slot for accommodating an external memory, and an external connection port and a wireless communication module for receiving an image source. The external connection port may be a universe serial bus ("USB") terminal, a display port, or a high-definition multimedia interface ("HDMI") terminal, and the wireless communication module may be a 5G communication module, a 4G communication module, a Wi-Fi module, or a Bluetooth module.

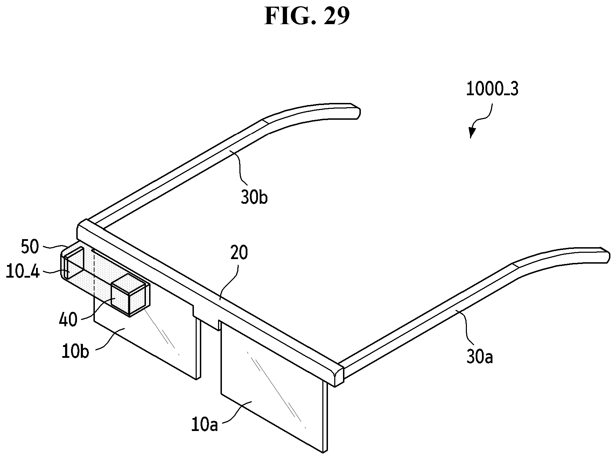

FIG. 29 is a perspective view of a VR device including a display device. FIG. 29 illustrates a VR device 1000_3 to which a display device 10_4 in an embodiment has been applied.

Referring to FIG. 29, the VR device 1000_3 in an embodiment may be a device in the form of glasses. The VR device 1000_3 in the embodiment may include the display device 10_4, a left lens 10a, a right lens 10b, a support frame 20, eyeglass frame legs 30a and 30b, a reflective member 40, and a display device housing 50.

In FIG. 29, a case where the VR device 1000_3 is a glasses-type display device including the eyeglass frame legs 30a and 30b is illustrated as an example. That is, the VR device 1000_3 in the embodiment is not limited to the one illustrated in FIG. 29 and may be applied in various forms to various other electronic devices.

The display device housing 50 may include the display device 10_4 and the reflective member 40. An image displayed on the display device 10_4 may be reflected by the reflective member 40 and provided to a user's right eye through the right lens 10b. Accordingly, the user may view a VR image displayed on the display device 10_4 through the right eye.

Although the display device housing 50 is disposed at a right end of the support frame 20 in FIG. 29, embodiments of the specification are not limited thereto. In an embodiment, the display device housing 50 may also be disposed at a left end of the support frame 20, for example. In this case, an image displayed on the display device 10_4 may be reflected by the reflective member 40 and provided to the user's left eye through the left lens 10a. Accordingly, the user may view a VR image displayed on the display device 10_4 through the left eye. In an alternative embodiment, the display device housing 50 may be disposed at both the right end and the left end of the support frame 20. In this case, the user may view a VR image displayed on the display device 10_4 through both the left eye and the right eye.

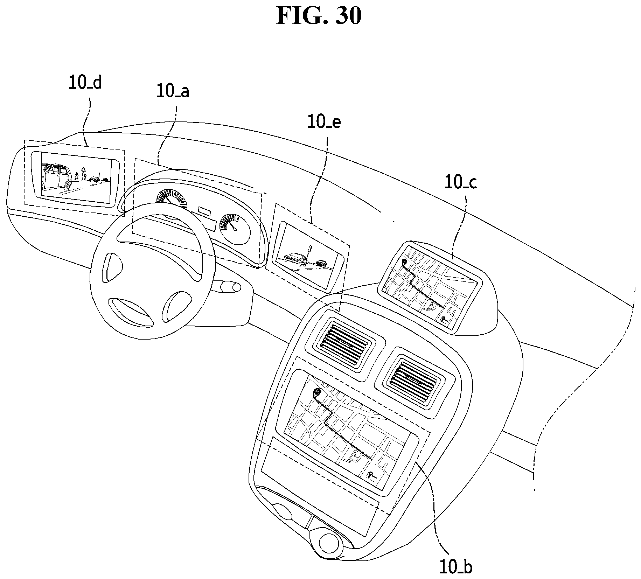

FIG. 30 is a perspective view illustrating a vehicle instrument cluster and center fascia including display devices. FIG. 30 illustrates a vehicle to which display devices 10_a through 10_e in an embodiment have been applied.

Referring to FIG. 30, the display devices 10_a through 10_c in the embodiment may be applied to an instrument cluster of the vehicle, a center fascia of the vehicle, or a center information display ("CID") disposed on a dashboard of the vehicle. In addition, the display devices 10_d and 10_e in the embodiment may be applied to room mirror displays that replace side mirrors of the vehicle.

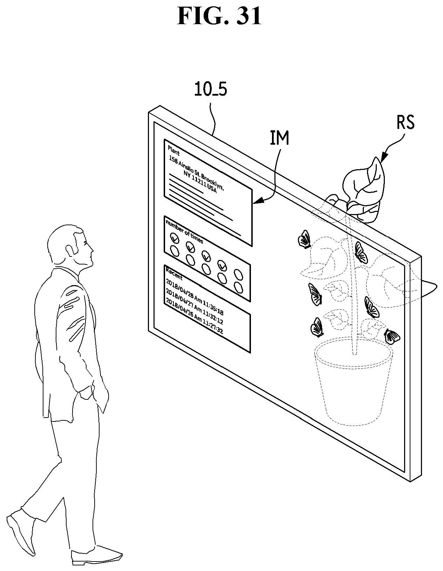

FIG. 31 is a perspective view of a transparent display device including a display device.

Referring to FIG. 31, a display device 10_5 in an embodiment may be applied to a transparent display device. The transparent display device may transmit light while displaying an image IM. Therefore, a user disposed in front of the transparent display device cannot only view the image IM displayed on the display device 10_5 but also view an object RS or the background disposed behind the transparent display device. When the display device 10_5 is applied to the transparent display device, a substrate of the display device 10_5 may include a light-transmitting portion that may transmit light or may include or consist of a material that may transmit light.

As discussed, embodiments may provide a light-emitting element transfer device comprising: a first transfer head; a second transfer head disposed below the first transfer head; a stamp disposed below the second transfer head; a tilting adjustment member arranged to adjust a tilting of the second transfer head; and an air supply member arranged to form an air layer by spraying air downward from a surface of the second transfer head.

The stamp may be adsorbed on one side of the second transfer head by the chuck.

The stamp may be disposed on a lower portion of the second transfer head.

The stamp may include a plurality of layers. In an embodiment, the stamp may include a base layer and a stamp layer, for example.

The base layer may support the stamp layer. The base layer may include or consist of, e.g., polyethylene terephthalate ("PET"), polyurethane (PU), polyimide ("PI"), polycarbonate ("PC"), polyethylene ("PE"), polypropylene ("PP"), polysulfone ("PSF"), polymethylmethacrylate ("PMMA"), triacetylcellulose ("TAC"), cycloolefin polymer ("COP"), or the like.

The stamp layer may be disposed on one side of the base layer. The stamp layer includes a plurality of protrusions and may adhere or bond the light-emitting element. The stamp layer may include or consist of an adhesive or adhesive material, and the adhesive material includes, e.g., an optical clear adhesive ("OCA"), a pressure sensitive adhesive ("PSA"), or the like, and the tacky material may include an acrylic-based, urethane-based, or silicone-based adhesive material, for example. One end of the plurality of protrusions is flat, and the shape of the protrusions may be a polygonal column or a cylinder.

The tilting adjustment member may adjust the relative flatness between the stamp and the substrate by adjusting the tilting of the second transfer head.

Embodiments may provide a method for transferring a light-emitting element comprising: disposing a transfer device on a substrate, the transfer device comprising: a first transfer head; a second transfer head disposed below the first transfer head; a stamp disposed below the second transfer head; a tilting adjustment member for adjusting the tilting of the second transfer head; and an air supply member for forming an air layer by spraying air downward from a surface of the second transfer head; the method comprising: lowering the transfer device by forming the air layer between the second transfer head and the substrate by the air supply member, wherein a thickness of the air layer is thicker than a sum of a height of the stamp and a height of the light-emitting element; adjusting a flatness of the transfer device to a flatness of the substrate; and lowering the second transfer head downward to pressurize the air layer to contact and transfer the light-emitting element to the substrate, wherein the thickness of the air layer is equal to the sum of the height of the stamp and the height of the light-emitting element.

A high-precision alignment may be performed by securing the relative flatness of the substrate while the light emitting element is not in contact with the substrate. Accordingly, the product quality of the display panel may be improved and the yield may be increased by reducing defects in the light emitting element. In particular, the effect may be excellent on a large-area substrate

In concluding the detailed description, those skilled in the art will appreciate that many variations and modifications may be made to the embodiments without substantially departing from the principles of the disclosure. Therefore, the disclosed embodiments of the disclosure are used in a generic and descriptive sense only and not for purposes of limitation.

## Claims

1. A light-emitting element transfer device comprising:
a first transfer head;
a second transfer head disposed below the first transfer head;
a stamp disposed below the second transfer head;
a tilting adjustment member arranged to adjust a tilting of the second transfer head; and
an air supply member arranged to form an air layer by spraying air downward from a surface of the second transfer head.

2. The device of claim 1, wherein the air supply member comprises:
an air supply portion arranged to supply air;
a spray head that is disposed on the surface of the second transfer head and has a hole through which air is sprayed; and
a spray line that penetrates the second transfer head and connects the air supply portion and the spray head.

3. The device of claim 2, wherein the hole is one of a single hole type or a porous type.

4. The device of claim 2 or 3, wherein the air supply portion is an air pump.

5. The device of any one of claims 1 to 4, wherein the first transfer head has a cavity defining an opening facing downward, and a width of the opening is smaller than a width of the cavity.

6. The device of claim 5, wherein the second transfer head is divided into a first portion disposed inside the cavity, a third portion disposed outside the first transfer head, and a second portion disposed between the first portion and the third portion, and a width of the second portion is narrower than a width of the first portion and a width of the third portion.

7. The device of claim 6, wherein the tilting adjustment member includes a first permanent magnet disposed on the first transfer head, and a second permanent magnet disposed on the first portion of the second transfer head and facing the first permanent magnet and having a repulsive force with the first permanent magnet.

8. The device of any one of claims 1 to 7, wherein the second transfer head has a chuck on one side and is arranged to absorb the stamp by the chuck.

9. The device of claim 5 or any claim when dependent on claim 5, wherein the second transfer head is divided into a first portion disposed inside the cavity, a third portion disposed outside the first transfer head, a second portion disposed between the first portion and the third portion, and an inclined portion disposed between the first portion and the second portion,
wherein a width of the second portion is narrower than a width of the first portion and a width of the third portion;
optionally wherein the tilting adjustment member includes a plurality of second permanent magnets disposed in the first portion and the inclined portion, and a plurality of first permanent magnets disposed on the first transfer member corresponding to the plurality of second permanent magnets.

10. The device of any one of claims 1 to 9, further comprising a pressure member which is disposed between the first transfer head and the second transfer head within a cavity of the first transfer head and presses the second transfer head downward;
optionally wherein the pressure member is a spring;
optionally wherein the pressure member includes an elastic film disposed on the second transfer head within the cavity of the first transfer head, a gas pipe connected between the elastic film and the cavity, and a gas supply member arranged to supply gas to the gas pipe.

11. The device of any one of claims 1 to 10, wherein the first transfer head, the second transfer head, and the tilting adjustment member are air gyros.

12. The device of any one of claims 1 to 11, wherein the spray head is provided in plural, and the spray heads are discontinuously disposed in a plurality around the stamp; or
wherein the spray head is provided in plural, and the spray heads are continuously disposed to surround the stamp.

13. A method for transferring a light-emitting element comprising:
disposing a transfer device on a substrate, the transfer device comprising:
a first transfer head;
a second transfer head disposed below the first transfer head;
a stamp disposed below the second transfer head;
a tilting adjustment member for adjusting the tilting of the second transfer head; and
an air supply member for forming an air layer by spraying air downward from a surface of the second transfer head; the method comprising:
lowering the transfer device by forming the air layer between the second transfer head and the substrate by the air supply member, wherein a thickness of the air layer is thicker than a sum of a height of the stamp and a height of the light-emitting element;
adjusting a flatness of the transfer device to a flatness of the substrate; and
lowering the second transfer head downward to pressurize the air layer to contact and transfer the light-emitting element to the substrate, wherein the thickness of the air layer is equal to the sum of the height of the stamp and the height of the light-emitting element.

14. The method of claim 13, wherein, in the disposing the transfer mechanism on the substrate, the light-emitting element disposed on the stamp is aligned on the substrate based on a first alignment key disposed on one side of the stamp and a second alignment key disposed on the substrate.

15. The method of claim 13 or 14, wherein, in the adjusting to the flatness of the substrate, the tilting adjustment member adjusts the second transfer head to adjust to the flatness of the substrate while the second transfer head is not in contact with the first transfer head; and/or
wherein, in the forming the air layer between the second transfer head and the substrate and the lowering the transfer device by the air supply member, an air supply unit supplies air to a spray head along a spray line, so that the spray head sprays air in a downward direction to form the air layer.
